# EUROPÄISCHE PATENTSCHRIFT

(11) **EP 3 290 155 B1**
(45) Veröffentlichungstag und Bekanntmachung des Hinweises auf die Patenterteilung: **04.11.2020**
(21) Anmeldenummer: 17186418.4
(22) Anmeldetag: 16.08.2017
(51) Int. Cl.: B24B 37/013, B24B 49/12, B24B 37/20, B24B 37/08, B24B 49/04

(54) **VERFAHREN ZUM MESSEN DER DICKE VON FLACHEN WERKSTÜCKEN**
METHOD FOR MEASURING THE THICKNESS OF FLAT WORKPIECES
PROCÉDÉ DE MESURE DE L'ÉPAISSEUR DE PIÈCES PLATES

(30) Priorität: 29.08.2016 DE 102016116012
(43) Veröffentlichungstag der Anmeldung: 07.03.2018
(73) Patentinhaber: Lapmaster Wolters GmbH, 24768 Rendsburg (DE)
(72) Erfinder: Kanzow, Jörn, 24103 Kiel (DE); Werth, Sascha, 24768 Rendsburg (DE)
(74) Vertreter: Hauck Patentanwaltspartnerschaft mbB

(56) Entgegenhaltungen:
- WO-A1-2010/037452
- WO-A1-2016/114458
- DE-A1- 3 213 252
- JP-A- 2002 170 800
- US-A- 5 969 521
- US-A1- 2002 053 358

## Beschreibung

Die Erfindung betrifft ein Verfahren zum Messen der Dicke von in einer Doppelseitenbearbeitungsmaschine bearbeiteten flachen Werkstücken. In Doppelseitenbearbeitungsmaschinen, beispielsweise Doppelseitenpoliermaschinen, werden flache Werkstücke, wie Wafer, insbesondere Siliziumwafer, materialabtragend bearbeitet. Bei diesem Abtragspolieren der Werkstücke ist eine Kontrolle der Werkstückdicke von essentieller Bedeutung für das Erreichen der Qualitätsanforderungen. Das Zielfenster zum Erreichen einer bestmöglichen Werkstückgeometrie beträgt ca. 100 nm. Wird das Zielmaß verpasst, beispielsweise weil der Bearbeitungsvorgang zu lange andauert, ist die Randgeometrie in der Regel nicht ausreichend für die Anforderungen der Wafer-Abnehmer. Insbesondere an die Flachheit der Werkstücke werden hohe Anforderungen gestellt. Typischerweise liegt die Anforderung an den Wafergeometrieparameter SFQRmax, d.h. den Höchstwert der lokalen Ebenheit ("site flatness") auf einem Siliziumwafer, bei 15 nm oder sogar bereits bei 10 nm. Bei anderen Bearbeitungsvorgängen, wie beispielsweise dem Hazefree-Polieren oder auch dem Schleifen besteht ebenfalls ein Erfordernis einer genauen Kenntnis der jeweiligen Werkstückdicke.

Es ist bekannt, mittels Wirbelstromsensoren den Abstand der Arbeitsscheiben und damit indirekt die Werkstückdicke zu messen. Damit können die eingangs erläuterten Genauigkeitsanforderungen allerdings nicht immer erreicht werden. Zudem ist diese Art der Messung von der Dicke und dem Verschleiß eines Arbeitsbelags auf der Arbeitsscheibe, wie eines Poliertuchs, abhängig. Üblich ist daher eine Vorhersage der Werkstückdicke anhand einer Vielzahl externer Parameter, wie der Eigenschaften des Poliermittels (Temperatur, pH-Wert, Alter, Verdünnung, Feststoff-Konzentration, Feststoff-Partikelgrößen) und des Poliertuchs (Art der Konditionierung, Art des Diamantabrichtens, Ebenheit, Form, Verschleiß, Verglasung) sowie Prozess- und Handlingzeiten. Durch Kontrolle dieser externen Parameter wird versucht, möglichst konstante Prozessbedingungen (eine wiederholbare Abtragsrate) einzuhalten. Die Dickenkontrolle erfolgt dann über die Prozesszeit und eine bekannte Vormessung. Auch mit dieser Methode lassen sich die eingangs erwähnten Genauigkeitsanforderungen allerdings regelmäßig nicht erreichen. Insbesondere verändern sich die externen Parameter während der Bearbeitung, beispielsweise durch Verschleiß. Hierdurch kommt es zu Abweichungen von der prognostizierten Werkstückdicke. Daher wird in der Regel nach der Bearbeitung in der Doppelseitenbearbeitungsmaschine eine externe Dickenmessung der Werkstücke durchgeführt. Dies ist sowohl messtechnisch als auch prozesstechnisch aufwendig. Insbesondere müssen die Wafer vor dem Messen in einer Reinigungsanlage gereinigt werden. Abhängig von der Produktionskapazität der Doppelseitenbearbeitungsmaschine muss eine erhebliche Messkapazität vorgehalten werden. Darüber hinaus kann auf diese Weise eine unzulässige Dickenabweichung erst nach der Bearbeitung festgestellt werden. Eine Korrektur der Prozessparameter der Bearbeitungsmaschine erfolgt entsprechend zeitversetzt und es entsteht Ausschuss.

Aus WO 2010/037452 A1 ist allgemein eine interferometrische Messung der Dicke von flachen Werkstücken, wie Wafern, bekannt. Auf diese Weise lässt sich die Werkstückdicke hochpräzise feststellen. Beispielsweise aus US 2006/0037699 A1, EP 1 970 163 B1, DE 11 2009 001 875 T5 oder US 6 437 868 B1 sind ebenfalls optische Messverfahren zur Dickenbestimmung flacher Werkstücke bekannt. Die Dickenmesseinrichtung ist dabei an der Bearbeitungsmaschine fest angeordnet und misst die Dicke der in der Maschine bearbeiteten Werkstücke beispielsweise durch eine Messöffnung in einem sich beispielsweise drehenden Teil der Maschine. Messungen sind dabei naturgemäß nur möglich, wenn die optische Achse der Messeinrichtung gerade zu der Messöffnung ausgerichtet ist. Dies ist in konstruktiver und prozesstechnischer Hinsicht aufwendig und es stehen nur relativ wenige Messpunkte zur Verfügung. Dies wiederum beeinträchtigt die Zuverlässigkeit und Genauigkeit der Messung.

Dokument US-A-2017/0355060 beschreibt eine Doppelseitenbearbeitungsmaschine zur Bearbeitung von flachen Werkstücken wobei die Werkstücke in einem zwischen einer oberen Arbeitsscheibe und einer unteren Arbeitsscheibe gebildeten Arbeitsspalt unter Relativdrehung der Arbeitsscheiben zueinander materialabtragend bearbeitet werden. Die Werkstückdicke wird mittels einer an der oberen Arbeitsscheibe angeordneten optischen Dickenmesseinrichtung optisch gemessen, wobei die Dickenmesseinrichtung die Werkstückdicke der in dem Arbeitsspalt befindlichen Werkstücke durch eine Durchgangsöffnung in der oberen Arbeitsscheibe hindurch misst.

Ausgehend von dem erläuterten Stand der Technik liegt der Erfindung daher die Aufgabe zugrunde, ein Verfahren der eingangs genannten Art bereitzustellen, mit dem in prozesstechnisch einfacher Weise eine zuverlässige und hochpräzise Dickenbestimmung von in einer Doppelseitenbearbeitungsmaschine bearbeiteten Werkstücken möglich ist.

Die Erfindung löst die Aufgabe durch den Gegenstand von Anspruch 1. Vorteilhafte Ausgestaltungen finden sich in den abhängigen Ansprüchen, der Beschreibung und den Figuren.

Bei der Doppelseitenbearbeitungsmaschine kann es sich beispielsweise um eine Doppelseitenpoliermaschine handeln. Es kann sich aber auch um eine andere Doppelseitenbearbeitungsmaschine handeln, wie beispielsweise eine Doppelseitenschleifmaschine. In dem Arbeitsspalt der Doppelseitenbearbeitungsmaschine können gleichzeitig mehrere Werkstücke beidseitig materialabtragend bearbeitet werden. Dazu sind die Arbeitsscheiben regelmäßig mit einem Arbeitsbelag, beispielsweise einem Polierbelag, versehen. Bekannt sind Läuferscheiben, die jeweils Öffnungen zur Aufnahme eines oder mehrerer Werkstücke, wie Halbleiterwafer, aufweisen, in denen die Werkstücke schwimmend gehalten sind. Die Läuferscheiben weisen an ihrem Außenumfang eine Verzahnung auf, die mit einer entsprechenden Verzahnung an der Außenseite und an der Innenseite des Arbeitsspalts kämmt. Dadurch dreht sich die Läuferscheibe im Arbeitsspalt und die Werkstücke werden entlang zykloider Bahnen durch den Arbeitsspalt geführt. Auf diese Weise kann eine besonders gleichmäßige Bearbeitung erreicht werden. Während der Bearbeitung kann eine der Arbeitsscheiben oder es können beide Arbeitsscheiben, dann gegenläufig drehend angetrieben werden. Derartige Doppelseitenbearbeitungsmaschinen sind an sich bekannt.

Erfindungsgemäß erfolgt mittels mindestens einer fest mit der oberen Arbeitsscheibe und/oder der unteren Arbeitsscheibe verbundenen optischen Dickenmesseinrichtung eine optische Messung der Werkstückdicke während der Bearbeitung der Werkstücke in dem Arbeitsspalt. Dazu weist die mit der Dickenmesseinrichtung ausgestattete obere und/oder untere Arbeitsscheibe eine Durchgangsöffnung auf, durch die hindurch die mit der jeweiligen Arbeitsscheibe mitdrehende Dickenmesseinrichtung die Werkstückdicke erfasst. Die Durchgangsöffnung erstreckt sich also von der optischen Dickenmesseinrichtung bis in den Arbeitsspalt, in dem sich die Werkstücke befinden. Die Arbeitsscheibe kann auch zweiteilig aufgebaut sein mit einem ersten Teil, der den Arbeitsspalt begrenzt und einem zweiten Teil, der den ersten Teil nach Art einer Trägerscheibe hält. Die Dickenmesseinrichtung kann dann entsprechend auch an dem als Träger ausgebildeten zweiten Teil befestigt sein.

Wie erläutert, arbeitet die erfindungsgemäße Dickenmesseinrichtung optisch und erreicht entsprechend eine hohe Präzision. Sie weist dazu eine optische Strahlungsquelle auf, zum Beispiel einen Laser. Die Strahlung der optischen Strahlungsquelle kann in einen Lichtleiter, wie eine Glasfaser, eingekoppelt werden, der die optische Strahlung über eine Fokussierungsoptik, umfassend beispielsweise Linsen, durch die Durchgangsöffnung hindurch auf die zu messenden Werkstücke richtet. Die Durchgangsöffnung bzw. Durchgangsbohrung, durch die die Dickenmesseinrichtung misst, kann insbesondere dezentral in der oberen und/oder unteren Arbeitsscheibe ausgebildet sein. Es versteht sich, dass bei Vorhandensein eines Arbeitsbelags auf der Arbeitsscheibe dieser Arbeitsbelag entsprechend ebenfalls die Durchgangsöffnung aufweisen muss, damit die im Arbeitsspalt befindlichen Werkstücke gemessen werden können.

Die während der Bearbeitung erfassten Messergebnisse der mindestens einen Dickenmesseinrichtung werden ebenfalls während der Bearbeitung der Werkstücke einer Steuereinrichtung zugeführt. Diese kann die Messwerte beispielsweise mit einer für die Werkstücke vorab festgelegten Zieldicke vergleichen. Sobald die Zieldicke erreicht ist, kann die Steuereinrichtung den aktuellen Bearbeitungsvorgang beenden. Dies kann das Ende des Bearbeitungsvorgangs der Werkstücke in der Bearbeitungsmaschine insgesamt sein. Es ist jedoch auch möglich, dass nach dem Ende des aktuellen Bearbeitungsvorgangs ein anderer nachfolgender Bearbeitungsvorgang beginnt, gesteuert wiederum von der Steuereinrichtung. Natürlich können die Messergebnisse vor dem Weiterleiten an die Steuereinrichtung auch bearbeitet werden. So können die Messergebnisse beispielsweise zunächst einem zwischengeschalteten Rechner o.ä. zugeführt werden, der die Dickenwerte der Dickenmesseinrichtung weiterverarbeitet und daraus gefilterte, geglättete oder anders bearbeitete Dickenwerte ermittelt, die schließlich an die Steuereinrichtung geschickt werden. Der Rechner o.ä. kann insoweit auch Teil der Steuereinrichtung sein.

Die erfindungsgemäße feste Verbindung der Dickenmesseinrichtung mit der Arbeitsscheibe bietet den Vorteil, dass schon im Fall einer einzigen Durchgangsöffnung in der Arbeitsscheibe zu jeder Zeit ein durch die sich drehende Arbeitsscheibe nicht unterbrochener Strahlengang in den Prozessbereich mit den Werkstücken, also den Arbeitsspalt, gerichtet wird. Damit sind im Gegensatz zu an einem Rahmen oder Gehäuse der Maschine nicht-drehend angeordneten Messeinrichtungen, wie sie im Stand der Technik vorgeschlagen wurden, auch kontinuierliche Dickenmessungen möglich. Jedenfalls werden der Umfang und die Anzahl der erhaltenen Messwerte nicht konstruktiv eingeschränkt, wie dies im Stand der Technik der Fall ist.

Außerdem bietet die Erfindung den Vorteil, dass die Durchgangsöffnung von der Seite der Dickenmesseinrichtung her abgedichtet werden kann, so dass Schmutz und Feuchtigkeit nicht in den Strahlengang und die Fokussierungsoptik der Dickenmesseinrichtung gelangen können. Gleichzeitig ist durch die erfindungsgemäße direkte optische Dickenmessung während der Bearbeitung in-situ eine präzise Dickenerfassung möglich, wobei eine aufwendige Vormessung und eine externe Nachmessung entfallen. Vielmehr kann die Steuereinrichtung den Bearbeitungsprozess nach Erreichen der vorgegebenen Zieldicke oder eines vorgegebenen Mindestabtrags automatisch beenden. Durch die erfindungsgemäße zuverlässige und präzise in-situ Bestimmung der Werkstückdicke werden Messkapazitäten an aufwendigen externen Messgeräten frei. Die Fertigungslogistik wird vereinfacht, da die Prozesshistorie nicht mehr zwingend bekannt sein muss. Ein exakt kontinuierlicher Betrieb zum Stabilisieren der Abtragsrate ist nicht mehr zwingend notwendig. Ausschuss wird verringert.

Wie bereits erwähnt, kann das erfindungsgemäße Verfahren in besonders vorteilhafter Weise bei der Bearbeitung von Wafern, beispielsweise (einkristallinen) Siliziumwafern, angewendet werden, und zwar sowohl bei gering p-dotierten als auch bei hoch p-dotierten Wafern. Dies gilt auch bei Bor-, Phosphor-, Arsen- oder anderen, auch gemischten, Dotierungen. Selbstverständlich ist das erfindungsgemäße Verfahren auch bei anderen Werkstücken vorteilhaft anwendbar, zum Beispiel einkistallinen, polykristallinen oder glasartigen Werkstücken aus Silizium, Siliziumcarbid, Aluminiumoxid, Silikat oder anderen Materialien.

Es handelt sich bei den Werkstücken um flache, bevorzugt ebene Werkstücke, die rund oder auch eckig sein können. Besonders bevorzugt sind Wafer in einem Durchmesserbereich zwischen ca. 100 mm und ca. 450 mm in den nach SEMI-Norm gestaffelten Durchmessern 100 mm, 125 mm, 150 mm, 200 mm, 300 mm und 450 mm, davon insbesondere Siliziumwafer mit dem Durchmesser 300 mm. Typische Dickenbereiche liegen im Bereich von 300 µm bis 950 µm, bei Siliziumwafern mit einem Durchmesser von 300 mm insbesondere zwischen 770 µm und 800 µm. Hier liegt die angestrebte Zieldicke der Werkstücke nach der vollständigen Waferbearbeitungs-Prozesskette typischerweise zwischen 770 µm und 780 µm und die Werkstückdicke während des Doppelseitenpolierens wegen des benötigten Aufmaßes i.d.R. zwischen 0 µm und bis zu 20 µm darüber. Abhängig beispielsweise von der Dotierung der Siliziumwerkstücke variiert die Absorption der optischen Strahlung in dem Werkstück, ebenso wie die optische Dichte des Materials.Beides, insbesondere jedoch letzteres, beeinflusst das Messergebnis. Ist die entsprechende Werkstückeigenschaft vorab bekannt, kann die Steuereinrichtung das Messverfahren entsprechend anpassen oder das Messergebnis in geeigneter Weise abändern, um diese Werkstückeigenschaften zu berücksichtigen. Hierzu kann es sich anbieten, Werkstücke in unterschiedliche Klassen zu unterteilen und einem Bediener der Doppelseitenbearbeitungsmaschine die Wahl der Klasse in der Steuereinrichtung zu ermöglichen. Alternativ könnten die Werkstückeigenschaften, zum Beispiel die Dotierkonzentration, als Zahlenwert in der Steuereinrichtung hinterlegt werden, die dann das Messergebnis in geeigneter Weise anpasst. Eine weitere Alternative wäre die Messung solcher Werkstückeigenschaften oder mit ihnen korrelierenden Eigenschaften, zum Beispiel Leitfähigkeit im Fall der Dotierkonzentration von Wafern, in der Doppelseitenbearbeitungsmaschine, so dass die Steuereinrichtung das Messergebnis wiederum in geeigneter Weise abändern kann. Abhängig von der Temperatur der Werkstücke variiert vor allem die optische Dichte des Materials. Dies beeinflusst wiederum das Messergebnis. Ist die Werkstücktemperatur während der Messung bekannt, kann dies wiederum in entsprechender Weise in der Steuereinrichtung berücksichtigt werden. Vorstellbar wären das Hinterlegen der für den jeweiligen Bearbeitungsvorgang erwarteten Temperatur in der Steuereinrichtung, die Klassifizierung unterschiedlicher Temperaturbereiche und/oder die Wahl eines Temperaturbereichs durch den Bediener. Auch das Nutzen von Temperaturmesswerten von Temperaturmesseinrichtungen, die der Steuereinrichtung zugehen, ist möglich. Hier bieten sich beispielsweise Temperaturen der Kühlmedien an, die regelmäßig den Arbeitsscheiben zugeführt werden. Gemessen werden können diese beispielsweise mittels geeigneter Messeinrichtungen im Zulauf oder Ablauf der Doppelseitenbearbeitungsmaschine oder auch im Kühlmittelreservoir. Auch können Temperaturen zugrunde gelegt werden, die mittels geeigneter Messeinrichtungen im, am oder nahe des Arbeitsspalts gemessen werden.

Es versteht sich, dass erfindungsgemäß insbesondere die optische Werkstückdicke bestimmt werden kann. Bei bekanntem oder ermitteltem Brechungsindex kann daraus dann die (mechanische) Werkstückdicke bestimmt werden.

Die gemessene Werkstückdicke kann erfindungsgemäß vor allem dazu verwendet werden, den jeweils aktuellen Bearbeitungsvorgang bei Erreichen oder Unterschreiten einer bestimmten Werkstückdicke zu beenden bzw. in einen nachfolgenden Bearbeitungsvorgang zu überführen. Ein der Steuereinrichtung entsprechend vorgegebenes Bearbeitungsprogramm kann dazu mehrere Bearbeitungsvorgänge beinhalten, die nacheinander jeweils bei Erreichen oder Unterschreiten einer zuvor festgelegten Zieldicke der Werkstücke beendet bzw. in den nächsten Bearbeitungsvorgang überführt werden können. Solche Bearbeitungsvorgänge können direkt oder mit Unterbrechungen aufeinander folgen. Natürlich kann die gemessene Werkstückdicke auch dazu verwendet werden, die aktuelle Werkstückabtragsrate zu bestimmen und Prozessparameter während der Werkstückbearbeitung in geeigneter Weise, beispielsweise über einen Algorithmus anzupassen, um die Abtragsrate auf ein vorgegebenes Maß zu bringen.

Die Vielzahl an Daten, die die mindestens eine Dickenmesseinrichtung an die Steuereinrichtung übermittelt, werden bevorzugt mit statistischen oder allgemeinmathematischen Methoden, einer Datenfilterung, Mittelung, einer Extrapolation bzw. einer Trendermittlung oder einer anderen Datenauswertung insbesondere mithilfe von Algorithmen so ausgewertet, dass zeitaufgelöst gute Repräsentanten für die Werkstückdicke das Ergebnis der Auswertung sind. Solche Algorithmen beinhalten eine Änderung der Messergebnisse bevorzugt aufgrund einer Kalibrierung und Korrekturen wie oben beschrieben.

Nach einer besonders bevorzugten Ausgestaltung kann die mindestens eine Dickenmesseinrichtung die Dicke der Werkstücke mittels eines interferometrischen Dickenmessverfahrens messen. Mittels interferometrischer Messverfahren kann die Werkstückdicke in besonders präziser Weise bestimmt werden. Voraussetzung sind für die optische Strahlung der mindestens einen Dickenmesseinrichtung teiltransparente und teilreflektierende Werkstücke, die also einen relevanten Anteil der optischen Strahlung durch das Werkstück hindurch und zurück passieren lassen. Ein interferometrisches Dickenmessverfahren ist beispielsweise bekannt aus der eingangs genannten WO 2010/037452 A1. Dieses Verfahren kann grundsätzlich im Rahmen der vorliegenden Erfindung zum Einsatz kommen. Dabei wird optische Strahlung auf die Werkstückoberseite gerichtet, wobei ein erster Strahlungsanteil an der Oberseite reflektiert wird und ein zweiter Strahlungsanteil die Werkstückdicke durchdringt, an der Werkstückunterseite reflektiert wird und wieder an der Werkstückoberseite austritt. Der erste und zweite Strahlungsanteil interferieren dann unter Bildung eines Interferenzmusters. Anhand dieses Interferenzmusters kann in der in WO 2010/037452 A1 beschriebenen Weise die optische Werkstückdicke zwischen der Werkstückoberseite und der Werkstückunterseite bestimmt werden. Bei bekanntem oder beispielsweise wie in WO 2010/037452 A1 beschrieben ermitteltem Brechungsindex kann daraus außerdem die mechanische Werkstückdicke bestimmt werden. Auch ist es möglich, ein Infrarotstrahlungsspektrum auf die Werkstückoberseite zu richten, wobei dann die durch Interferenz der Strahlungsanteile entstandene Strahlung mittels eines Spektrometers analysiert werden kann.

Eine optische Strahlungsquelle der mindestens einen Dickenmesseinrichtung kann insbesondere Infrarotstrahlung aussenden. Dies ist besonders günstig bei der Dickenmessung von, insbesondere hochdotierten Siliziumwerkstücken, das heißt gezielt mit Fremdatomen wie Bor oder Phosphor versehenen Siliziumwerkstücken. Bevorzugt sendet die optische Strahlungsquelle Infrarotstrahlung im Wellenlängenbereich zwischen 1050 nm und 1600 nm aus, weil Silizium in diesem Wellenlängenbereich besonders transparent ist. Weiter bevorzugt liegt dieser Wellenlängenbereich zwischen 1150 nm und 1350 nm.

Mindestens eine Fokussierungsoptik der mindestens einen Dickenmesseinrichtung ist ln der mindestens einen Durchgangsöffnung ; angeordnet. Eine Verringerung des Abstands zwischen der Fokussierungsoptik, die beispielsweise geeignete Linsen oder Ähnliches umfassen kann, und den zu messenden Werkstücken, erhöht die Lichtausbeute und damit die erzielbare Signalqualität. Insbesondere Werkstücke mit einem hohen Lichtabsorptionsgrad können nur bei ausreichender Lichtausbeute mit hinreichender Präzision bestimmt werden. Die Dicke der Arbeitsscheibe kann in diesem Zusammenhang bereits problematisch sein. Daher ist vorgesehen, dass die Fokussierungsoptik in die Arbeitsscheibe eingelassen ist und so einen geringen Abstand zum Werkstück aufweist.

Die Fokussierungsoptik kann nach einer weiteren Ausgestaltung eine Schärfentiefe von mindestens 1 mm, vorzugsweise mindestens 2 mm besitzen. Eine Schwierigkeit des Dickenmessverfahrens ist der sich verändernde Abstand zwischen der Fokussierungsoptik und dem Werkstück. Insbesondere variiert die Dicke des üblicherweise dazwischen befindlichen Arbeitsbelags, wie eines Poliertuchs, der Arbeitsscheibe abhängig von dem Arbeitsbelagtyp und dem Verschleiß. Die messtechnisch bestimmte Werkstückdicke soll aber mit einer Abweichung von möglichst weniger als +/- 0,1 µm, insbesondere ca. +/- 0,05 µm unabhängig von diesen Umständen bestimmt werden. Daher ist bei dieser Ausgestaltung eine Fokussierungsoptik vorgesehen, die eine große Schärfentiefe aufweist. Um die erzielbare Genauigkeit zu erhöhen, kann die Fokussierungsoptik weiterhin mechanisch so verstellbar sein, dass die Schärfentiefe den Prozessbereich, das heißt den Bereich, in dem sich das Werkstück während der unterschiedlichen Bearbeitungszustände befindet, voll einschließt bzw. in die Mitte der Schärfentiefe setzt. Die mechanische Verstellung kann dabei so realisiert sein, dass sie beispielsweise in Unterbrechungen zwischen Bearbeitungsvorgängen vorgenommen werden kann. Denkbar ist grundsätzlich auch eine angesteuerte Mechanik, die während des Bearbeitungsvorgangs oder nach einer Verstellvorschrift, die weitere Parameter wie beispielsweise eine Poliertuchdicke einbezieht, eingesetzt wird.

Die mindestens eine Durchgangsöffnung kann im Bereich ihres Zugangs zum Arbeitsspalt mit Druckluft gespült werden. Auch ist es möglich, in der mindestens einen Durchgangsöffnung einen Überdruck gegenüber dem Arbeitsspalt zu erzeugen. Beides dient dem Schutz der Dickenmesseinrichtung, insbesondere einer Fokussierungsoptik, vor Verunreinigungen aus dem Arbeitsspalt. Dieser Schutz kann auch mit einem Shutter kombiniert werden, der den Strahlengang nur für die Dauer eines Messvorgangs freigibt.

Besonders bevorzugt ist jedoch, wenn in der mindestens einen Durchgangsöffnung zwischen der Dickenmesseinrichtung und dem Arbeitsspalt mindestens ein für optische Strahlung einer optischen Strahlungsquelle der mindestens einen Dickenmesseinrichtung zumindest teiltransparentes Schutzfenster angeordnet ist. Das Schutzfenster kann insbesondere im Wesentlichen vollständig transparent für die Strahlung der optischen Strahlungsquelle sein. Die Dicke eines solchen Schutzfensters liegt bevorzugt in einem Bereich zwischen 0,5 mm und 20 mm, besonders bevorzugt zwischen 2 mm und 10 mm. Insbesondere im Fall von Siliziumwerkstücken sind Materialien für die Schutzfenster geeignet, die im Bereich der Infrarotstrahlung transparent sind. Bevorzugte Materialien für das Schutzfenster sind Aluminiumoxid oder Calciumfluorid. Vorteilhaft ist zudem eine hohe chemische Beständigkeit der Schutzfenster insbesondere gegenüber alkalischen Medien, die typischerweise als Poliermittel in Doppelseitenpoliermaschinen eingesetzt werden. Grundsätzlich vorteilhafte Eigenschaften sind eine geringe oder dem Arbeitsscheibenmaterial ähnliche Temperaturausdehnung, eine hohe Kratzfestigkeit und eine geringe Neigung zu Brüchen.

Nach einer weiteren Ausgestaltung kann das mindestens eine Schutzfenster gegenüber der den Arbeitsspalt begrenzenden Oberfläche der mit der mindestens einen Durchgangsöffnung versehenen Arbeitsscheibe um höchstens 10 mm, vorzugsweise höchstens 3 mm, weiter vorzugsweise höchstens 1 mm, höchst vorzugsweise höchstens 0,3 mm zurückstehen. Indem sich die werkstückseitige Oberfläche des Schutzfensters nahe an der Arbeitsscheibenoberfläche befindet, füllt sich der Raum zwischen dem Arbeitsspalt und dem Schutzfenster im Betrieb schnell homogen mit einem Arbeitsmedium, beispielsweise einem Poliermittel. Außerdem strömt das Arbeitsmedium gleichmäßig, wenig turbulent und unter geringer Blasenbildung an dem Schutzfenster vorbei. Dies könnte anderenfalls zu instabilen Messergebnissen führen. Das nur geringe Zurückstehen des Schutzfensters kann auch nützlich sein, um störende Messsignale vermeiden zu helfen, z.B. aufgrund eines Arbeitsmediumfilms, z.B. eines Poliermittelfilms, zwischen dem Werkstück und dem Schutzfenster. Dessen Dicke wäre dann entsprechend begrenzt und ein Messsignal ließe sich von dem Signal der Werkstückdicke unterscheiden und herausfiltern.

In einer weiteren Ausführung kann das mindestens eine Schutzfenster gegenüber der den Arbeitsspalt begrenzenden Oberfläche der mit der mindestens einen Durchgangsöffnung versehenen Arbeitsscheibe um mindestens 2 mm und höchstens 10 mm zurückstehen. Anders als bei der oben erläuterten Ausgestaltung könnte auch ein größeres Zurückstehen des Schutzfensters vorteilhaft sein, in der oben beschriebenen Ausgestaltung mindestens 2 mm, so dass der Arbeitsmediumfilm besonders dick wäre. Dessen Dicke wäre dann nach unten begrenzt und ein gegebenenfalls auftretendes Messsignal ließe sich dann von dem Signal der Werkstückdicke unterscheiden und herausfiltern.

Auch in Bezug auf die oben genannten Ausgestaltungen sei noch darauf hingewiesen, dass das Schutzfenster keine ebene Oberfläche aufweisen muss, insbesondere in Richtung des Arbeitsspalts. Die oben genannten Zahlenwerte beziehen sich dann auf das Zurückstehen des am weitesten vorragenden Teils des Schutzfensters. Es kann insoweit ausreichen, wenn ein Großteil des Lichts durch den Bereich des Schutzfensters geführt wird, der in der Geometrie den oben beschriebenen Ausgestaltungen entspricht.

Das mindestens eine Schutzfenster kann von der Seite des Arbeitsspalts her durch eine Reinigungseinrichtung mittels einer Reinigungsflüssigkeit gereinigt werden. Zusätzlich zu oder anstelle einer Spülung des Arbeitsspalts mit einem freispülenden Prozessmedium, zum Beispiel deionisiertem Wasser oder einer Lauge, während oder kurz vor Ende des Bearbeitungsvorgangs, kann das Schutzfenster auch nach einem Bearbeitungsvorgang, zwischen zwei Bearbeitungsvorgängen oder vor einem Bearbeitungsvorgang mit einer Reinigungseinrichtung freigespült werden. Dies kann unter geringem Druck manuell erfolgen. Bevorzugt ist allerdings ein Verfahren, bei dem das Schutzfenster von der Werkstückseite her regelmäßig mit einer druckbeaufschlagten Reinigungsflüssigkeit, z. B. mit deionisiertem Wasser oder einer Lauge, freigespült wird. Dies kann automatisiert durch die Steuereinrichtung erfolgen. Bevorzugt kann es sich hierbei um die gleiche Einrichtung handeln, die zum Freispülen oder Auffrischen der Arbeitsbeläge der Arbeitsscheiben verwendet wird. Der Raum zwischen dem Arbeitsspalt und dem Schutzfenster kann auch während des Bearbeitungsvorgangs gezielt mit einer Flüssigkeit, vorzugsweise mit Wasser, einer Lauge oder dem Arbeitsmedium selbst versorgt werden, um dem zuvor beschriebenen Problem zu begegnen, dass das Arbeitsmedium turbulent und unter Blasenbildung an dem Schutzfenster vorbeifließt.

Nach einer weiteren Ausgestaltung kann vorgesehen sein, dass die Werkstückdicke während der Bearbeitung der Werkstücke durch mehrere in der oberen Arbeitsscheibe und/oder der unteren Arbeitsscheibe ausgebildeten Durchgangsöffnungen optisch gemessen wird. Die Dickenmessung durch die unterschiedlichen Durchgangsöffnungen ist dabei grundsätzlich (pro Arbeitsscheibe) mit einer gemeinsamen Dickenmesseinrichtung möglich, wobei die Strahlung der optischen Strahlungsquelle der Dickenmesseinrichtung dann in geeigneter Weise, beispielsweise mittels Strahlteilern, aufgeteilt werden kann. Natürlich ist es aber auch denkbar, dass hierzu mehrere Dickenmesseinrichtungen an der oberen Arbeitsscheibe oder an der unteren Arbeitsscheibe angeordnet sind. Die Messung der Werkstückdicke durch die unterschiedlichen Durchgangsöffnungen während der Bearbeitung kann gleichzeitig erfolgen. Es ist aber auch eine Messung der Werkstückdicke durch die unterschiedlichen Durchgangsöffnungen während der Bearbeitung zu unterschiedlichen Zeitpunkten, also versetzt zueinander, möglich.

Wie bereits erläutert, können in der Doppelseitenbearbeitungsmaschine gleichzeitig mehrere Werkstücke bearbeitet werden. Dabei können Fehlmessungen aussortiert werden, so dass nur oder bevorzugt Messwerte berücksichtigt werden, die ermittelt wurden während sich tatsächlich ein Werkstück im Strahlengang der optischen Dickenmesseinrichtung befand. Es ist dann weiter möglich, die Messergebnisse der mindestens einen Dickenmesseinrichtung jeweils eindeutig einem Werkstück zuzuordnen. Dies erfordert in hoher zeitlicher Präzision Kenntnis über die Position und bestenfalls auch die Verdrehung der Läuferscheiben sowie der Arbeitsscheiben. Diese Informationen stehen aber abhängig von der Maschinenkonfiguration zur Verfügung. Zusätzlich kann die Anzahl der Messwerte auch auf andere Weise eingeschränkt werden, zum Beispiel durch gepulste Dickenmessungen, wobei der Strahlungspuls über einen Shutter im Strahlengang, eine elektrische Schaltung oder eine Aussortierung aufgrund eines Algorithmus erfolgen kann.

Nach einer weiteren Ausgestaltung kann vorgesehen sein, dass die mindestens eine Dickenmesseinrichtung schwingungsgedämpft an der oberen Arbeitsscheibe und/oder der unteren Arbeitsscheibe angeordnet ist. Durch die schwingungsgedämpfte, bestenfalls schwingungsisolierte Lagerung der Dickenmesseinrichtung, beispielsweise eines Spektrometers einer Auswerteeinheit der Dickenmesseinrichtung, kann eine Verfälschung der Messergebnisse durch Schwingungen verringert oder vermieden werden. In dem hier betroffenen Bearbeitungsprozess treten Schwingungen mit typischen Frequenzen zwischen 10 Hz und 1000 Hz, insbesondere zwischen 100 Hz und 1000 Hz auf. Die Schwingungsdämpfung kann eine aktive, elektronische Schwingungsdämpfung sein oder eine passive Schwingungsdämpfung, beispielsweise eine elastische Lagerung, abgestimmt auf das betreffende Frequenzband. Es kann auf diese Weise auch eine mechanische oder thermisch induzierte mechanische Verspannung zwischen der Arbeitsscheibe und der Dickenmesseinrichtung, beispielsweise einer Auswerteeinheit der Dickenmesseinrichtung vermieden werden.

Die Steuereinrichtung kann an einem von den Arbeitsscheiben getrennten Ort angeordnet sein. Die Datenübertragung zwischen der mindestens einen Dickenmesseinrichtung und der Steuereinrichtung und die elektrische Versorgung der mindestens einen Dickenmesseinrichtung können dann über mindestens einen Schleifkontakt erfolgen. Eine Auswerteeinheit der an der oberen und/oder unteren Arbeitsscheibe angeordneten mindestens einen Dickenmesseinrichtung weist regelmäßig ein optisches Gitter und beispielsweise einen CCD-Sensor auf. Es muss einerseits die Datenübertragung, d. h. die Übertragung elektrischer Messsignale, zwischen der auf der sich drehenden Arbeitsscheibe befindlichen Dickenmesseinrichtung und der sich nicht drehenden, getrennt von der Arbeitsscheibe angeordneten Steuereinrichtung der Doppelseitenbearbeitungsmaschine sichergestellt werden. Als geeigneter Schleifkontakt kommt ein Schleifring in Frage, insbesondere mit Goldkontakten. Gleiches gilt andererseits auch für die elektrische Versorgung der Dickenmesseinrichtung. Der Signalaustausch kann dabei direkt oder mittelbar bzw. über ein BUS-System, zum Beispiel ProfiBUS oder ProfiNET, erfolgen.

Ein Ausführungsbeispiel der Erfindung wird nachfolgend anhand von Figuren näher erläutert. Es zeigen schematisch:
- Fig.1: eine Doppelseitenbearbeitungsmaschine zur Durchführung des erfindungsgemäßen Verfahrens,
- Fig. 2: ein Histogramm zur Veranschaulichung eines Verfahrens des Standes der Technik, und
- Fig. 3: ein Histogramm zur Veranschaulichung des erfindungsgemäßen Verfahrens.

Soweit nichts anderes angegeben ist, bezeichnen in den Figuren gleiche Bezugszeichen gleiche Gegenstände.

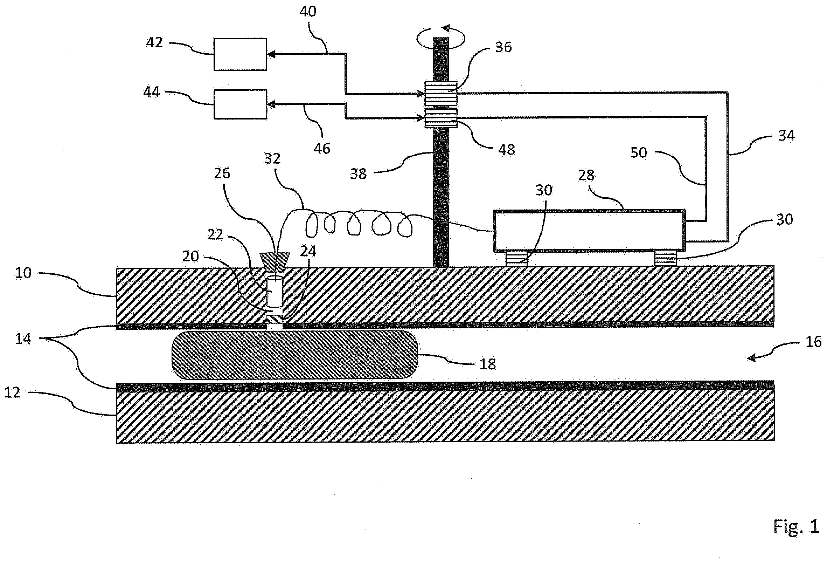

Bei der in Fig. 1 gezeigten Doppelseitenbearbeitungsmaschine kann es sich beispielsweise um eine Doppelseitenpoliermaschine handeln. Die Doppelseitenbearbeitungsmaschine weist eine obere Arbeitsscheibe 10 und eine der oberen Arbeitsscheibe 10 gegenüberliegende untere Arbeitsscheibe 12 auf. Teil der oberen Arbeitsscheibe 10 und der unteren Arbeitsscheibe 12 kann jeweils ein Arbeitsbelag 14, beispielsweise ein Poliertuch, sein. Mit diesem Arbeitsbelag 14 begrenzen die obere und untere Arbeitsscheibe 10, 12 zwischen sich einen Arbeitsspalt 16 zur materialabtragenden Bearbeitung von Werkstücken. Bei dem Bezugszeichen 18 ist beispielhaft veranschaulichend ein Werkstück, beispielsweise ein Wafer, gezeigt. Es versteht sich, dass in der Praxis im dem Arbeitsspalt 16 beispielsweise drehbar angeordnete Läuferscheiben vorgesehen sein können, die jeweils mehrere Werkstücke zur gleichzeitigen Bearbeitung in dem Arbeitsspalt 16 aufnehmen.

In der oberen Arbeitsscheibe 10 ist in dem gezeigten Beispiel eine Durchgangsöffnung 20, insbesondere eine Durchgangsbohrung, ausgebildet. In der Durchgangsöffnung 20 befindet sich eine Fokussierungsoptik 22 einer an der oberen Arbeitsscheibe 10 befestigten Dickenmesseinrichtung. Die Fokussierungsoptik 22 kann beispielsweise geeignete Linsen umfassen. Zwischen der Fokussierungsoptik 22 und dem Arbeitsspalt 16 ist in dem gezeigten Beispiel ein Schutzfenster 24 in der Durchgangsöffnung 20 angeordnet. Das andere Ende der Durchgangsöffnung 20 ist durch ein geeignetes Dichtelement 26 abgebildet. Die Dickenmesseinrichtung umfasst darüber hinaus eine Mess- und Auswerteeinheit 28, die über Schwingungsdämpfer 30 auf der Oberseite der oberen Arbeitsscheibe 10 befestigt ist. In der Mess- und Auswerteeinheit 28 ist einerseits eine optische Strahlungsquelle angeordnet, beispielsweise ein Laser, bevorzugt ein Infrarotlaser. Die von der optischen Strahlungsquelle ausgesandte Strahlung wird über einen Lichtwellenleiter 32, insbesondere eine Glasfaser, zu der Fokussierungsoptik 22 geleitet und von dieser durch das für die optische Strahlung zumindest teiltransparente Schutzfenster 24 auf das Werkstück 18 fokussiert. In der Mess- und Auswerteeinheit 28 befindet sich außerdem ein optischer Strahlungssensor, beispielsweise ein CCD-Sensor und beispielsweise ein optisches Gitter. Die Mess- und Auswerteeinheit 28 steuert die Strahlungsquelle zum Aussenden von optischer Strahlung an. Diese wird teilweise an der Oberseite des Werkstücks 18 reflektiert, tritt teilweise in das Werkstück 18 ein, wird an der Unterseite des Werkstücks 18 reflektiert und tritt nach erneutem Durchlauf durch das Werkstück 18 wieder an der Oberseite aus. Die von der Werkstückoberseite und Werkstückunterseite zurückkommende optische Strahlung wird über die Fokussierungsoptik 22 und den Lichtwellenleiter 32 zu dem in der Mess- und Auswerteeinheit 28 angeordneten Sensor geleitet und gelangt zur Interferenz. Die von dem Sensor empfangenen Messsignale können in der Mess- und Auswerteeinheit 28 ausgewertet werden, um die Werkstückdicke 18 zu ermitteln. Insbesondere kann die Werkstückdicke interferometrisch ermittelt werden, wie dies beispielsweise in der WO 2010/037452 A1 beschrieben ist.

Über eine Signalleitung 34 gelangen die Messwerte zu einem Drehübertrager 36, beispielsweise einem Schleifring, der im Bereich der Antriebswelle 38 der Doppelseitenbearbeitungsmaschine vorgesehen ist, über die die obere Arbeitsscheibe 10 im Betrieb drehend angetrieben wird. Der Drehübertrager 36 ist mit seinem anderen Ende über eine weitere Signalleitung 40 mit einer Steuereinrichtung 42 (SPS) der Doppelseitenbearbeitungsmaschine verbunden. Bei dem Bezugszeichen 44 ist außerdem eine Spannungsversorgung für die Dickenmesseinrichtung gezeigt. Die Versorgung erfolgt über eine erste Spannungsleitung 46, einen weiteren Drehübertrager 48, beispielsweise wiederum einen Schleifring, der wiederum an der Antriebswelle 38 angeordnet ist, und eine zweite mit der Dickenmesseinrichtung verbundene Spannungsleitung 50.

Mit dem mit dieser Doppelseitenbearbeitungsmaschine durchgeführten erfindungsgemäßen Verfahren lässt sich die Werkstückdicke während der Bearbeitung in zuverlässiger und präziser Weise ermitteln. Stellt die Steuereinrichtung 42 das Erreichen einer zuvor festgelegten Zieldicke anhand der zur Verfügung gestellten Messergebnisse fest, beendet die Steuereinrichtung 42 den aktuellen Bearbeitungsvorgang. Anschließend kann die Steuereinrichtung 42 den vorgegebenen folgenden Bearbeitungsschritt starten oder die Bearbeitung der Werkstücke insgesamt beenden.

Aus Veranschaulichungsgründen ist in Fig. 1 nur eine Dickenmesseinrichtung gezeigt, die über nur eine Durchgangsöffnung die Werkstückdicke misst. Es ist selbstverständlich möglich, dass gleichzeitig oder zeitlich versetzt zueinander die Werkstückdicke durch mehrere Durchgangsöffnungen hindurch gemessen wird, sei dies mittels mehrerer an der oberen Arbeitsscheibe 10 und/oder der unteren Arbeitsscheibe 12 angeordneter Dickenmesseinrichtungen oder nur mittels einer Dickenmesseinrichtung, deren Strahlengang in geeigneter Weise aufgeteilt wird, wie dies grundsätzlich oben beschrieben ist.

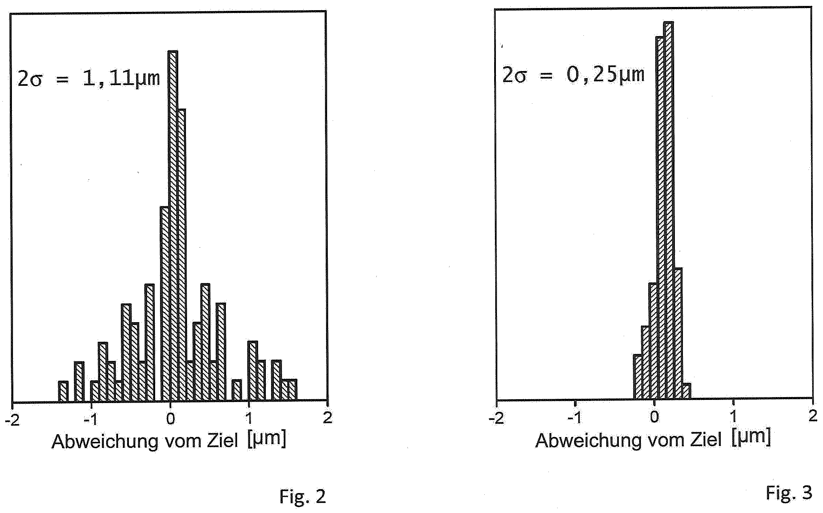

In Fig. 2 ist für ein konventionelles Doppelseitenbearbeitungsverfahren ohne die erfindungsgemäße Dickenmessung für eine Mehrzahl bearbeiteter Werkstücken, hier Wafern, eine Häufigkeitsverteilung der für die Werkstücke nach der Bearbeitung ermittelten Dickenmesswerte bzw. ihrer Abweichung von der Zieldicke dargestellt. In Fig. 3 ist für dieselbe Doppelseitenbearbeitungsmaschine, in diesem Fall jedoch mit der erfindungsgemäßen Dickenbestimmung, für eine Mehrzahl an bearbeiteten Werkstücken, vorliegend wiederum Wafern, eine Häufigkeitsverteilung der nach der Bearbeitung ermittelten Dickenmesswerte bzw. ihrer Abweichung von der Zieldicke dargestellt. Erkennbar ist die Dickenabweichung bei Anwendung des erfindungsgemäßen Verfahrens erheblich geringer als bei dem konventionellen Verfahren. Insbesondere liegt die doppelte Standardabweichung 2σ bei dem erfindungsgemäßen Verfahren nur bei 0,25 µm während sie bei dem konventionellen Verfahren bei 1,11 µm liegt.

## Patentansprüche

1. Verfahren zum Messen der Dicke von in einer Doppelseitenbearbeitungsmaschine bearbeiteten flachen Werkstücken (18), umfassend die Schritte:
- die Werkstücke werden in einem zwischen einer oberen Arbeitsscheibe (10) und einer unteren Arbeitsscheibe (12) der Doppelseitenbearbeitungsmaschine gebildeten Arbeitsspalt (16) unter Relativdrehung der Arbeitsscheiben (10, 12) zueinander materialabtragend bearbeitet,
- während der Bearbeitung der Werkstücke (18) wird die Werkstückdicke mittels mindestens einer an der oberen Arbeitsscheibe (10) und/oder der unteren Arbeitsscheibe (12) angeordneten optischen Dickenmesseinrichtung optisch gemessen, wobei die mindestens eine Dickenmesseinrichtung die Werkstückdicke der in dem Arbeitsspalt (16) befindlichen Werkstücke (18) durch mindestens eine Durchgangsöffnung (20) in der oberen Arbeitsscheibe (10) und/oder der unteren Arbeitsscheibe (12) hindurch misst,
- die Messergebnisse der mindestens einen Dickenmesseinrichtung werden einer Steuereinrichtung (42) der Doppelseitenbearbeitungsmaschine zugeführt,
- bei Erreichen einer zuvor festgelegten Zieldicke der Werkstücke (18) beendet die Steuereinrichtung (42) den Bearbeitungsvorgang der Werkstücke,
- **dadurch gekennzeichnet, dass** mindestens eine Fokussierungsoptik (22) der mindestens einen Dickenmesseinrichtung in der mindestens einen Durchgangsöffnung (20) angeordnet ist.

2. Verfahren nach Anspruch 1, **dadurch gekennzeichnet, dass** die mindestens eine Dickenmesseinrichtung die Dicke der Werkstücke (18) mittels eines interferometrischen Dickenmessverfahrens misst.

3. Verfahren nach einem der vorhergehenden Ansprüche, **dadurch gekennzeichnet, dass** eine optische Strahlungsquelle der mindestens einen Dickenmesseinrichtung Infrarotstrahlung aussendet.

4. Verfahren nach Anspruch 3, **dadurch gekennzeichnet, dass** die Fokussierungsoptik (22) eine Schärfentiefe von mindestens 1 mm, vorzugsweise mindestens 2 mm, besitzt.

5. Verfahren nach einem der vorhergehenden Ansprüche, **dadurch gekennzeichnet, dass** die mindestens eine Durchgangsöffnung (20) im Bereich ihres Zugangs zum Arbeitsspalt (16) mit Druckluft gespült wird.

6. Verfahren nach einem der vorhergehenden Ansprüche, **dadurch gekennzeichnet, dass** in der mindestens einen Durchgangsöffnung (20) ein Überdruck gegenüber dem Arbeitsspalt (16) erzeugt wird.

7. Verfahren nach einem der vorhergehenden Ansprüche, **dadurch gekennzeichnet, dass** in der mindestens einen Durchgangsöffnung (20) zwischen der Dickenmesseinrichtung und dem Arbeitsspalt (16) mindestens ein für optische Strahlung einer optischen Strahlungsquelle der mindestens einen Dickenmesseinrichtung zumindest teiltransparentes Schutzfenster (24) angeordnet ist.

8. Verfahren nach Anspruch 7, **dadurch gekennzeichnet, dass** das mindestens eine Schutzfenster (24) aus Aluminiumoxid oder Calciumfluorid besteht.

9. Verfahren nach einem der Ansprüche 7 oder 8, **dadurch gekennzeichnet, dass** das mindestens eine Schutzfenster (24) gegenüber der den Arbeitsspalt (16) begrenzenden Oberfläche der mit der mindestens einen Durchgangsöffnung (20) versehenen Arbeitsscheibe um höchstens 10 mm, vorzugsweise höchstens 3 mm, weiter vorzugsweise höchstens 1 mm, höchst vorzugsweise höchstens 0,3 mm zurücksteht.

10. Verfahren nach einem der Ansprüche 7 bis 9, **dadurch gekennzeichnet, dass** das mindestens eine Schutzfenster (24) von der Seite des Arbeitsspalts (16) durch eine Reinigungseinrichtung mittels einer Reinigungsflüssigkeit gereinigt wird.

11. Verfahren nach einem der vorhergehenden Ansprüche, **dadurch gekennzeichnet, dass** die Werkstückdicke während der Bearbeitung der Werkstücke (18) durch mehrere in der oberen Arbeitsscheibe (10) und/oder der unteren Arbeitsscheibe (12) ausgebildeten Durchgangsöffnungen (20) optisch gemessen wird.

12. Verfahren nach Anspruch 11, **dadurch gekennzeichnet, dass** die Messung der Werkstückdicke durch die unterschiedlichen Durchgangsöffnungen (20) während der Bearbeitung gleichzeitig erfolgt.

13. Verfahren nach Anspruch 11, **dadurch gekennzeichnet, dass** die Messung der Werkstückdicke durch die unterschiedlichen Durchgangsöffnungen (20) während der Bearbeitung zu unterschiedlichen Zeitpunkten erfolgt.

14. Verfahren nach einem der vorhergehenden Ansprüche, **dadurch gekennzeichnet, dass** in der Doppelseitenbearbeitungsmaschine gleichzeitig mehrere Werkstücke (18) bearbeitet werden, wobei die Messergebnisse der mindestens einen Dickenmesseinrichtung jeweils eindeutig einem Werkstück (18) zugeordnet werden.

15. Verfahren nach einem der vorhergehenden Ansprüche, **dadurch gekennzeichnet, dass** die mindestens eine Dickenmesseinrichtung schwingungsgedämpft an der oberen Arbeitsscheibe (10) und/oder der unteren Arbeitsscheibe (12) angeordnet ist.

16. Verfahren nach einem der vorhergehenden Ansprüche, **dadurch gekennzeichnet, dass** die Steuereinrichtung an einem von den Arbeitsscheiben (10, 12) getrennten Ort angeordnet ist.

17. Verfahren nach Anspruch 16, **dadurch gekennzeichnet, dass** die Datenübertragung zwischen der mindestens einen Dickenmesseinrichtung und der Steuereinrichtung (42) und die elektrische Versorgung der mindestens einen Dickenmesseinrichtung über mindestens einen Schleifkontakt erfolgen.

## Claims

1. A method for measuring the thickness of flat workpieces (18) processed in a double-sided processing machine, comprising the following steps:
- the workpieces are processed in a working gap (16) formed between an upper working disk (10) and a lower working disk (12) of the double-sided processing machine, involving rotating the working disks (10, 12) relative to one another in such a way that material is removed,
- the workpiece thickness is optically measured during the processing of the workpieces (18) by means of at least one optical thickness measurement apparatus arranged on the upper working disk (10) and/or the lower working disk (12), wherein the at least one thickness measurement apparatus measures the workpiece thickness of the workpieces (18) located in the working gap (16) through at least one through-hole (20) in the upper working disk (10) and/or the lower working disk (12),
- the measurement results of the at least one thickness measurement apparatus are supplied to a control apparatus (42) of the double-sided processing machine,
- once a previously specified target thickness of the workpieces (18) is reached, the control apparatus (42) terminates the processing operation of the workpieces,
- **characterized in that** at least one focusing optic (22) of the at least one thickness measurement apparatus is arranged in the at least one through-hole (20).

2. The method according to Claim 1, **characterized in that** the at least one thickness measurement apparatus measures the thickness of the workpieces (18) by means of an interferometric thickness measurement method.

3. The method according to any one of the preceding claims, **characterized in that** an optical radiation source of the at least one thickness measurement apparatus emits infrared radiation.

4. The method according to Claim 3, **characterized in that** the focusing optic (22) has a focus depth of at least 1 mm, preferably at least 2 mm.

5. The method according to any one of the preceding claims, **characterized in that** the at least one through-hole (20) is flushed with compressed air in the region of its entry to the working gap (16).

6. The method according to any one of the preceding claims, **characterized in that** an excess pressure with respect to the working gap (16) is generated in the at least one through-hole (20).

7. The method according to any one of the preceding claims, **characterized in that** at least one protective window (24) which is at least partially transparent to optical radiation from an optical radiation source of the at least one thickness measurement apparatus is arranged in the at least one through-hole (20) between the thickness measurement apparatus and the working gap (16).

8. The method according to Claim 7, **characterized in that** the at least one protective window (24) consists of aluminum oxide or calcium fluoride.

9. The method according to any one of Claims 7 or 8, **characterized in that** the at least one protective window (24) is recessed by a maximum of 10 mm with respect to the surface delimiting the working gap (16) of the working disk provided with the at least one through-hole (20), preferably by a maximum of 3 mm, more preferably by a maximum of 1 mm, most preferably by a maximum of 0.3 mm.

10. The method according to any one of Claims 7 to 9, **characterized in that** the at least one protective window (24) is cleaned from the side of the working gap (16) by a cleaning apparatus by means of a cleaning fluid.

11. The method according to any one of the preceding claims, **characterized in that** the workpiece thickness during the processing of the workpieces (18) is optically measured through multiple through-holes (20) configured in the upper working disk (10) and/or the lower working disk (12).

12. The method according to Claim 11, **characterized in that** the workpiece thickness is measured through the different through-holes (20) simultaneously during the processing.

13. The method according to Claim 11, **characterized in that** the workpiece thickness is measured through the different through-holes (20) at different times during the processing.

14. The method according to any one of the preceding claims, **characterized in that** multiple workpieces (18) are processed simultaneously in the double-sided processing machine, wherein the measurement results of the at least one thickness measurement apparatus are in each case clearly allocated to one workpiece (18).

15. The method according to any one of the preceding claims, **characterized in that** the at least one thickness measurement apparatus is arranged in a vibration-dampened manner on the upper working disk (10) and/or the lower working disk (12).

16. The method according to any one of the preceding claims, **characterized in that** the control apparatus is arranged at a separate location from the working disks (10, 12).

17. The method according to Claim 16, **characterized in that** the data transfer takes place between the at least one thickness measurement apparatus and the control apparatus (42) and the electrical supply of the at least one thickness measurement apparatus via at least one sliding contact.

## Revendications

1. Procédé de mesure de l'épaisseur de pièces plates (18) traitées dans une machine de traitement bifacial, comportant les étapes suivantes :
- les pièces sont traitées par enlèvement de matériau dans une fente de travail (16) formée entre un disque de travail supérieur (10) et un disque de travail inférieur (12) de la machine de traitement bifacial, par rotation relative des disques de travail (10, 12) l'un par rapport à l'autre,
- pendant le traitement des pièces (18), l'épaisseur de pièce est mesurée optiquement à l'aide d'au moins un dispositif de mesure d'épaisseur optique disposé sur le disque de travail supérieur (10) et/ou sur le disque de travail inférieur (12), l'au moins un dispositif de mesure d'épaisseur mesurant l'épaisseur de pièce des pièces (18) se trouvant dans la fente de travail (16) à travers au moins une ouverture de passage (20) dans le disque de travail supérieur (10) et/ou dans le disque de travail inférieur (12),
- les résultats de mesure de l'au moins un dispositif de mesure d'épaisseur sont transmis à un dispositif de commande (42) de la machine de traitement bifacial,
- lors de l'atteinte d'une épaisseur cible prédéfinie des pièces (18), le dispositif de commande (42) termine le processus de traitement des pièces,
- **caractérisé en ce qu'**au moins une optique de focalisation (22) de l'au moins un dispositif de mesure d'épaisseur est disposée dans l'au moins une ouverture de passage (20).

2. Procédé selon la revendication 1, **caractérisé en ce que** l'au moins un dispositif de mesure d'épaisseur mesure l'épaisseur des pièces (18) à l'aide d'un procédé de mesure d'épaisseur interférométrique.

3. Procédé selon l'une des revendications précédentes, **caractérisé en ce qu'**une source de rayonnement optique de l'au moins un dispositif de mesure d'épaisseur émet un rayonnement infrarouge.

4. Procédé selon la revendication 3, **caractérisé en ce que** l'optique de focalisation (22) possède une profondeur de champ d'au moins 1 mm, de préférence d'au moins 2 mm.

5. Procédé selon l'une des revendications précédentes, **caractérisé en ce que** l'au moins une ouverture de passage (20) est rincée à l'air comprimé dans la région de son accès à la fente de travail (16).

6. Procédé selon l'une des revendications précédentes, **caractérisé en ce qu'**une surpression est établie dans l'au moins une ouverture de passage (20) par rapport à la fente de travail (16).

7. Procédé selon l'une des revendications précédentes, **caractérisé en ce qu'**au moins une fenêtre de protection (24) au moins partiellement transparente au rayonnement optique d'une source de rayonnement optique de l'au moins un dispositif de mesure d'épaisseur est disposée dans l'au moins une ouverture de passage (20) entre le dispositif de mesure d'épaisseur et la fente de travail (16).

8. Procédé selon la revendication 7, **caractérisé en ce que** l'au moins une fenêtre de protection (24) est constituée d'oxyde d'aluminium ou de fluorure de calcium.

9. Procédé selon la revendication 7 ou 8, **caractérisé en ce que** l'au moins une fenêtre de protection (24) est en retrait de 10 mm maximum, de préférence de 3 mm maximum, plus préférentiellement de 1 mm maximum, et encore plus préférentiellement de 0,3 mm maximum, par rapport à la surface délimitant la fente de travail (16) du disque de travail pourvu de l'au moins une ouverture de passage (20).

10. Procédé selon l'une des revendications 7 à 9, **caractérisé en ce que** l'au moins une fenêtre de protection (24) est nettoyée depuis le côté de la fente de travail (16) par un dispositif de nettoyage à l'aide d'un liquide de nettoyage.

11. Procédé selon l'une des revendications précédentes, **caractérisé en ce que** l'épaisseur de pièce est mesurée optiquement pendant le traitement des pièces (18), à travers plusieurs ouvertures de passage (20) formées dans le disque de travail supérieur (10) et/ou dans le disque de travail inférieur (12).

12. Procédé selon la revendication 11, **caractérisé en ce que** le mesurage de l'épaisseur de pièce est effectué simultanément à travers les différentes ouvertures de passage (20) pendant le traitement.

13. Procédé selon la revendication 11, **caractérisé en ce que** le mesurage de l'épaisseur de pièce à travers les différentes ouvertures de passage (20) est effectué à différents moments pendant le traitement.

14. Procédé selon l'une des revendications précédentes, **caractérisé en ce que** plusieurs pièces (18) sont traitées simultanément dans la machine de traitement bifacial, les résultats de mesure de l'au moins un dispositif de mesure d'épaisseur étant attribués respectivement de façon univoque à une pièce (18).

15. Procédé selon l'une des revendications précédentes, **caractérisé en ce que** l'au moins un dispositif de mesure d'épaisseur est disposé sur le disque de travail supérieur (10) et/ou sur le disque de travail inférieur (12) de manière à amortir les vibrations.

16. Procédé selon l'une des revendications précédentes, **caractérisé en ce que** le dispositif de commande est disposé à un endroit séparé des disques de travail (10, 12).

17. Procédé selon la revendication 16, **caractérisé en ce que** la transmission de données entre l'au moins un dispositif de mesure d'épaisseur et le dispositif de commande (42) et l'alimentation électrique de l'au moins un dispositif de mesure d'épaisseur sont effectuées par le biais d'au moins un contact frottant.
